Europäisches Patentamt

(19) European Patent Office

Office européen des brevets

(11) Numéro de publication: **0 240 526**
**B1**

(12) **FASCICULE DE BREVET EUROPÉEN**

(45) Date de publication du fascicule du brevet:
07.02.90

(21) Numéro de dépôt: 86905839.6

(22) Date de dépôt: 23.09.86

(86) Numéro de dépôt international:
PCT/FR 86/00322

(87) Numéro de publication international:
WO 87/01738 (26.03.87 Gazette 87/07)

(51) Int. Cl.⁵: **C 23 C  8/36, C 23 C  16/50,**
**H 01 J  37/32**

(54) PROCEDE ET DISPOSITIF DE TRAITEMENT CHIMIQUE, NOTAMMENT DE TRAITEMENT THERMOCHIMIQUE ET DE DEPOT CHIMIQUE DANS UN PLASMA HOMOGENE DE GRAND VOLUME.

(30) Priorité: 24.09.85 FR 8514138

(43) Date de publication de la demande:
14.10.87 Bulletin 87/42

(45) Mention de la délivrance du brevet:
07.02.90 Bulletin 90/06

(84) Etats contractants désignés:
AT BE CH DE FR GB IT LI LU NL SE

(56) Documents cité:
EP-A-0 016 909
EP-A-0 062 550
EP-A-0 129 490
EP-A-0 149 408
DE-A-2 606 937
DE-A-3 322 680

(73) Titulaire: CENTRE NATIONAL DE LA RECHERCHE SCIENTIFIQUE (CNRS)
15, Quai Anatole France
F-75007 Paris (FR)

(72) Inventeur: VANDENBULCKE, Lionel, Gérard
131bis, rue Demay
F-45650 Saint Jean Le Blanc (FR)

(74) Mandataire: Moncheny, Michel
c/o Cabinet Lavoix 2 Place d'Estienne d'Orves
F-75441 Paris Cedex 09 (FR)

EP 0 240 526 B1

LIBERGRAF, STOCKHOLM 1990

## Description

La présente invention est relative aux traitements chimiques et notamment à la formation de revêtements de diffusion par traitement thermochimique et à la formation de couches minces par dépôt chimique, sur de nombreux substrats de formes quelconques, dans un plasma homogène de grand volume formé à partir d'un milieu gazeux adéquat s'écoulant dans une enceinte à parois chaudes ou froides.

On connaît dans l'état de la technique un certain nombre de moyens pour faire diffuser des espèces provenant d'une phase gazeuse dans un solide ou pour effectuer des dépôts chimiques à partir d'un plasma.

Ainsi par exemple, on connaît un procédé de nitruration ionique mettant en oeuvre une cathode et une anode dans lequel la cathode sert de support aux pièces à traiter et l'anode est constituée par les parois de l'enceinte. Un plasma se développe au voisinage de la surface des pièces lorsqu'on applique une différence de potentiel comprise entre 300 et 1000 V entre les deux électrodes, un débit de gaz nitrurant étant maintenu en régime dynamique sous une pression de 1 à quelques Torr dans l'enceinte. Ce procédé, où le chauffage des pièces vers 500°C est assuré par un bombardement ionique, n'est pas idéal en ce qui concerne la précision de la température et son homogénéité. Il ne s'applique qu'à de grandes séries de pièces toutes identiques.

Des procédés de nitruration ionique utilisent également des décharges radiofréquences ou micro-ondes, mais ces moyens ne permettent pas d'obtenir un plasma de grand volume homogène.

On connaît également des procédés de dépôt chimique dans des décharges continues ou radiofréquences, mais les mêmes inconvénients que ceux cités ci-dessus sont inhérents à ces techniques. Ces méthodes qui fournissent un plasma de température électronique élevée ne permettent pas non plus de disposer de paramètres indépendants pour la génération du plasma et son interaction avec la surface des substrats. Ils n'ont été appliqués qu'aux traitements de substrats plans pour la microélectronique.

Par ailleurs, on connaît la production de plasmas excités par filament thermoémissif ou par ondes hyperfréquences, qui sont maintenus spatialement par un confinement magnétique associé ou non à un confinement électrostatique. Les plasmas obtenus possèdent une température électronique plus faible, une forte densité et peuvent être homogènes dans un grand volume. Il existe de plus une véritable indépendance des paramètres de génération du plasma et de son utilisation. Lorsque l'excitation est obtenue par filament thermoémissif, divers inconvénients proviennent de la fiabilité dans le temps du filament et de la pollution du milieu ambiant dont il est responsable. Enfin, il est exclu d'utiliser ce type d'excitation en présence d'un milieu gazeux réactif vis-à-vis de la matière constitutive du filament.

Lorsque l'excitation est réalisée par ondes hyperfréquences, on dispose d'un plasma de grand volume, homogène, dense, de faible température électronique et gazeuse, produit à partir d'un milieu réactif ou non et dont les paramètres de génération sont indépendants de ceux de son utilisation.

Dans ce dernier cas, on connaît le traitement de substrats divers pour l'industrie microélectronique. Il s'agit alors de substrats plans placés sur un porte-substrats thermostaté. Cette technique ne permet en aucun cas de traiter des pièces métallurgiques de formes quelconques à des températures des pièces dépassant largement la température obtenue dans le seul plasma, spécialement vers 350 - 550°C, et présente un inconvénient majeur pour le traitement de nombreux substrats pour la microélectronique à ces mêmes températures.

La demande de brevet européen EP-A-2-0 149 408 décrit un procédé et un dispositif pour le dépôt d'une couche mince d'un matériau sur un support à partir d'un plasma réactif.

Suivant la caractéristique principale le plasma est à très basse pression comprise entre 13,3 et 1,33 $10^{-3}$ Pa et le substrat est chauffé de manière indépendante par le porte-substrat qui possède des moyens de régulation de la température de ce substrat. Le plasma est obtenu par des moyens connus tel qu'un filament thermoémissif ou des ondes hyperfréquences et maintenu à l'intérieur d'une enceinte par un confinement magnétique.

Un tel procédé et le dispositif associé ne permettent pas de porter une partie du contenu de l'enceinte à une température de l'ordre de 500°C et les calories sont apportées par le porte-substrat et le plasma.

La demande de brevet européen EP-A-0 016 909 décrit une enceinte comprenant des moyens pour créer un plasma indépendants de ceux utilisés pour le chauffage du substrat, le plasma et le substrat étant dans deux zones distinctes de températures au sein de l'enceinte. Le substrat est en effet placé en dehors du plasma et chauffé par le porte-substrat qui possède son propre chauffage. De plus l'application concerne la croissance d'oxyde à partir du substrat semi-conducteur soumis à un courant d'oxygène actif qui se déplace, par les différences de pression à l'intérieur de l'enceinte, du plasma vers le substrat.

Toutes les techniques précédentes utilisent soit un chauffage par le plasma lui-même, soit un chauffage par un porte-substrats thermostaté. Elles ne permettent donc pas d'envisager le traitement, sous plasma, de nombreuses pièces de formes quelconques à des températures de quelques centaines de degrés centigrades.

L'objet de la présente invention est de remédier aux inconvénients de la technique antérieure en proposant un procédé et un dispositif basés sur l'association, d'une part d'un plasma froid à très basse pression ($10^{-2}$ à $10^{-5}$ Torr ou encore 1,33 Pa à 0,00133 Pa) qui lorsqu'il est seul, est caractérisé par une température gazeuse très faible, et apporte une quantité de calories négligeable aux substrats, et d'autre part d'un chauffage indépendant et distinct du plasma, qui élève la température gazeuse du plasma et chauffe les substrats mais qui est disposé de façon à limiter l'interaction des espèces chargées avec les parties les plus chaudes du dispositif qui sont, par exemple, les parois de l'enceinte.

L'invention met donc en oeuvre un traitement thermochimique ou de dépôt chimique sous plasma par exemple en réacteur à parois chaudes et permet ainsi de traiter ensemble des substrats de formes et dimensions quelconques et non identiques. Il s'agit d'un plasma continu, de grand volume homogène, de grande densité à basse pression, excité et maintenu indépendamment de l'interaction avec les substrats et dont la température gazeuse, proche de celle des substrats, est fixée par un moyen extérieur à une valeur pratiquement indépendante de l'existence du plasma.

A cet effet, la présente invention a pour objet un procédé de traitement chimique, notamment de traitement thermochimique ou de dépôt chimique, sous plasma, sur des substrats disposés sur un ou plusieurs porte-substrats, comprenant par l'association simultanée d'un plasma à très basse pression, comprise entre 1,33 Pa et 0,00133 Pa et d'un chauffage indépendant le plasma étant obtenu par l'excitation d'un milieu gazeux réactif à l'aide d'un filament thermoémissif ou d'ondes hyperfréquences et maintenu à l'intérieur d'une enceinte par un confinement magnétique, caractérisé en ce que le chauffage indépendant comprend une résistance répartie le long des parois de l'enceinte à l'intérieur ou à l'extérieur telle qu'elle permette de porter une partie du contenu de l'enceinte à une température au plus égale à environ 550°C, la proportion de calories apportées par le seul plasma au chauffage des substrats étant négligeable.

Selon un autre aspect, l'invention a également pour objet un dispositif pour la mise en oeuvre du procédé tel que défini précédemment, comprenant:

- une enceinte, étanche et raccordée à un circuit d'apport d'un ou de plusieurs gaz et à un système de pompage éventuellement régulé par l'intermédiaire d'une jauge et d'une vanne, l'ensemble permettant de maintenir dans l'enceinte un débit gazeux sous une pression déterminée, comprise entre 1,33 et 0,00133 Pa,
- des moyens de génération de plasma constitués soit d'un filament thermoémissif disposé à l'intérieur de l'enceinte, soit d'un générateur d'ondes hyperfréquences connecté à un dispositif d'excitation du mileu gazeux,
- une enveloppe de confinement magnétique interne à l'enceinte étanche,
- caractérisé en ce que les propriétés de ladite enveloppe sont maintenues jusqu'à une température au plus égale à environ 550°C, et en ce que
- des moyens de chauffage permettent de porter une partie du contenu de l'enceinte à une température au plus égale à environ 550°C, en présence du plasma, la température de la paroi de l'enceinte pouvant être très supérieure à cette température.

L'invention sera mieux comprise à l'aide de la description qui va suivre donnée uniquement à titre d'exemple et faite en se référant aux dessins annexés sur lesquels:

- la fig. 1 représente une vue schématique générale d'un dispositif à double enceinte conforme à l'invention, et
- la fig. 2 représente une paroi chauffée d'une enceinte entrant dans la constitution d'un dispositif selon l'invention.

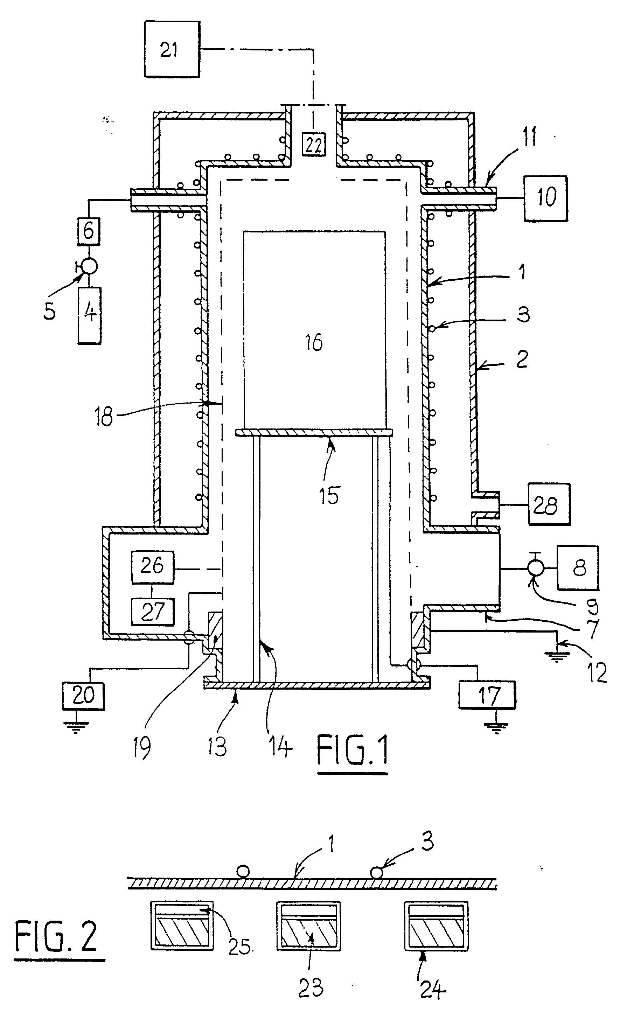

Sur la fig. 1, on a représenté une première enceinte chauffée 1, de préférence en matériau amagnétique, par exemple en acier inoxydable, entourée par une seconde enceinte 2 et des moyens de chauffage constitués par une résistance 3 disposée à l'extérieur de la première enceinte 1 le long de sa paroi assurant le chauffage dans toute la partie supérieure de la première enceinte. Cette première enceinte est reliée par une tubulure à des moyens de distribution d'un ou de plusieurs gaz provenant de réservoirs 4 qui peuvent être isolés de l'enceinte par une vanne d'arrêt 5. Les débits de gaz sont régulés par des débitmètres 6. L'enceinte 1 est également reliée par une tubulure 7 à un système de pompage 8, de vanne de réglage 9 étant disposée entre cette enceinte et ce système. Une jauge de pression 10 est également reliée à l'enceinte 1 par l'intermédiaire d'une tubulure 11. Il est ainsi possible de faire circuler un débit de gaz connu sous une pression absolue régulée entre 1,33 et 0,00133 Pa dans l'enceinte 1.

L'enceinte 1 est reliée à la masse 12 par tout moyen connu.

Le volume interne de l'enceinte 1 est accessible par une ouverture ménagée dans le fond de celle-ci, hors de la zone de chauffage et qui est fermée par un panneau amovible 13 qui supporte, par l'intermédiaire de pieds isolants 14, un porte-substrats 15. Les substrats à traiter sont placés dans un volume utile 16 et peuvent être polarisés directement ou, comme il est représenté, par l'intermédiaire du porte-substrats 15, de façon continue ou alternative, par une source de tension 17 reliée à celui-ci. Cependant, les substrats peuvent également être a potentiel flottant.

Le volume interne de l'enceinte 1 contient une enveloppe 18 de confinement magnétique constituée par une cage multipolaire maintenue par des supports isolants 19. Cette cage multipolaire peut être mise à la masse ou polarisée par l'intermédiaire d'une source de tension 20. Cette cage est constituée de barreaux aimantés de façon permanente, placés à l'intérieur de tubes métalliques étanches, de section parallélipédiques, disposés parallèlement et légèrement écartés les uns des présentent, en regard du volume interne, une face de polarité successivement différente de façon à créer dans le volume interne un effet réflecteur pour les électrons du plasma qui est ainsi confiné. L'armature métallique, constituée par les tubes et des entretoises de maintien en position de ces tubes, est réalisée en matériau amagnétique, par exemple en acier inoxydable.

Il est important que les aimants permanents conservent une aimantation à la température de traitement. Les matériaux employés sont ceux qui ont une perte d'aimantation faible avec la température et conservent leurs propriétés à la température la plus élevée possible, par exemple les alliages Nialco et Ticonal dont le changement de structure n'intervient qu'à une température comprise entre 450 et 500°C pour les premiers, et 550° C pour les seconds, la perte d'aimantation n'étant que de 0,02 % par degré C.

Un générateur 21 d'ondes hyperfréquences (dans la gamme 1 à 10 gigahertz) permet d'exciter le milieu gazeux par tout moyen approprié 22. Le plasma ainsi produit diffuse dans tout le volume délimité par la cage multipolaire. Dans une variante non représentée, le milieu gazeux est excité à partir d'un filament thermoémissif. Ce type d'excitation est évidemment réservé à un milieu gazeux non réactif vis-à-vis de l'élément constitutif du filament.

Lorsque l'excitation du milieu gazeux est réalisée par ondes hyperfréquences, celles-ci peuvent avantageusement être voisines de 2,45 gigahertz.

Pour améliorer le confinement du plasma, l'enveloppe de confinement magnétique est avantageusement complétée par des moyens de confinement électrostatique. Ils comprennent, par exemple, un revêtement isolant recouvrant toutes les parties métalliques de la cage multipolaire 18 tournées vers le volume interne où est maintenu le plasma. Ce revêtement isolant doit évidemment résister aux températures auxquelles est portée cette partie du dispositif.

Pour les températures de traitement les plus élevées, il est nécessaire de refroidir les aimants permanents. La Figure 2 montre la paroi chauffée de l'enceinte 1 et des aimants 23 placés dans des gaines 24, en acier inoxydable par exemple. Les gaines comportent une tubulure étanche permettant le passage d'un fluide thermique 25. Toutes les tubulures sont reliées de façon que le fluide de transfert thermique circule, en circuit fermé, à l'aide d'une pompe 26 (Fig. 1) entre les parties chaudes des gaines et une source froide 27. La pompe et la source froide sont situées dans un logement prévu à cet effet dans l'enceinte 1, et située dans la partie inférieure du dispositif, par exemple diamétralement opposée à la tubulure 7, de façon à laisser entièrement libre l'intérieur de l'enveloppe 18 pour le chargement et le déchargement des substrats.

Divers fluides organiques permettent d'opérer jusqu'à 400°C. Au dessus, les seuls fluides utilisables, mis à part les gaz chauds sont les métaux et les sels fondus. Parmi ceux-ci on peut employer le sel HTS jusqu'à 550°C.

Ainsi la paroi de l'enceinte 1 peut être portée à une température nettement supérieure à 550°C, tout en maintenant à une valeur plus faible la température des aimants de façon à conserver leurs propriétés.

Deux régulations de température non représentées ici permettent de régler et maintenir la température des substrats à une valeur déterminée en agissant sur les moyens de chauffage 3, et de maintenir la température des gaines 24 à une valeur compatible avec les propriétés des aimants et fixée, quelque soit la température de la paroi de l'enceinte 1, en agissant sur la source froide 27.

D'autre part le dispositif est tel que seules les espèces gazeuses neutres peuvent atteindre les parois de l'enceinte portées à température élevée, ce qui limite considérablement l'interaction de celles-ci avec les espèces du plasma.

Enfin la mise en température des pièces à revêtir peut être effectuée sous une pression de gaz inerte très supérieure à la pression employée pendant le traitement, de façon à augmenter les transferts thermiques, et la seconde enceinte 2 peut être refroidie et mise sous vide à l'aide d'un système de pompage 28.

En suite de quoi et quel que soit le mode de réalisation adopté, on dispose d'un procédé et d'un dispositif qui permettent de traiter à une température comprise entre 100 et environ 550 °C, des pièces de formes et de dimensions quelconques toutes portées à la même température, dans un plasma continu, de grand volume homogène, de grande densité (de l'ordre de $10^{10}$ cm$^{-3}$) à basse pression (1,33 Pa à 0,00133 Pa), dont les paramètres de génération sont indépendants de ceux de l'interaction du plasma avec la surface des substrats.

L'invention permet deux types de traitements principaux, les traitements thermochimiques et les dépôts chimiques.

Parmi les traitements thermochimiques, on peut citer par exemple la nitruration ionique des alliages métalliques qui est réalisée le plus souvent entre 480 et 550°C suivant les nuances et les structures recherchées. Au contraire de la technique antérieure, l'invention permet de traiter dans une opération différents types de pièces sans précaution particulière quant à leur disposition ou leurs tailles respectives, les calories nécessaires à leur chauffage provenant principalement de l'enceinte chauffée. Ceci est un avantage important par rapport à la technique antérieure qui ne permet le traitement que de grandes séries de pièces identiques.

Parmi les dépôts chimiques réalisés sur substrats métallurgiques, on peut citer par exemple le dépôt chimique du bore à partir de $B_2H_6+H_2$ ou Ar, réalisé entre 150 et 450°C, et du carbure de titane vers 500°C à partir de $TiCl_4 + CH_4 + Ar$.

Parmi les traitements thermochimiques et de dépôt chimique pour la microélectronique, on peut citer par exemple les traitements de gravure ou d'oxydation, et les dépôts chimiques du silicium mais aussi les dépôts des oxydes, nitrures et oxynitrures de silicium réalisés vers 350°C. Il s'agit alors de substrats plans et toute disposition de ces substrats les uns par rapport aux autres et à l'intérieur du volume utile 16 ainsi que tout système de déplacement ou rotation de ceux-ci font partie intégrante de l'invention. Plusieurs séries de substrats plans, places parallèlement entre eux, comme en LPCVD, et animés d'un mouvement de rotation, peuvent être disposées par exemple, à une distance égale de l'axe du dispositif, à l'intérieur du volume utile 16. de façon à effectuer un dépôt homogène sur un grand nombre de substrats en une seule opération.

Diverses variantes permettent de compléter le procédé et le dispositif décrits précédemment.

Une variante du dispositif consiste en l'utilisation de tubes amovibles contenant les aimants permanents placés eux-mêmes à l'intérieur de tubes étanches fixes sortant de l'enceinte étanche 1 et des moyens de chauffage, de façon que les tubes intérieurs contenant les aimants puissent être sortis sans arrêter la circulation de gaz sous pression réduite, ni les moyens de chauffage. Des traitements thermiques sous atmosphère contrôlée à une pression quelconque, ou sous vide, peuvent alors être réalisés à température très supérieure à 550°C.

Cette variante permet, par exemple, d'effectuer un dépôt de bore sur un alliage puis de le faire diffuser à une température comprise entre 550 et 750°C de façon à obtenir un ou plusieurs borures. On obtient ainsi μm de borure de fer en 5 heures à 600°C sur un acier XC 48. Il s'agit d'une couche uniforme qui ne présente pas les irrégularités, dues aux cristaux en aiguille de Fe2B, des couches de borures réalisées par les méthodes classiques de boruration à température élevée.

Un autre mode de réalisation du dispositif consiste à placer les gaines contenant les aimants permanents à l'extérieur de l'enceinte étanche 1, éventuellement isolées de celle-ci par un feutre de quelques millimètres d'épaisseur et refroidies par ventilation ou circulation d'un liquide. Le chauffage est alors effectué à l'intérieur de l'enceinte 1 par de multiples résistances chauffantes, gainées en Inconel ou en acier inoxydable et maintenues entre elles de façon à constituer une enveloppe chauffante située à l'intérieur de l'enceinte 1 à une distance de l'ordre de quelques millimètres des parois internes de celle-ci. De façon à limiter l'impact des électrons sur cette enveloppe, elle peut être revêtue d'une couche isolante et les gaines chauffantes sont de préférence positionnées en face des espaces ménagés entre les gaines contenant les aimants. Ainsi des températures de traitement plus élevées que les températures d'utilisation des aimants sont produites dans le volume utile 16 sans avoir nécessairement recours à un refroidissement localisé comme dans le mode de réalisation précèdent.

La température limite d'utilisation des aimants sera évidemment repoussée en fonction de l'utilisation d'aimants conservant leurs propriétés jusqu'à des températures plus élevées.

L'invention n'est pas limitée aux exemples décrits et représentés car diverses modifications particulières peuvent y être apportées, et des milieux réactifs divers utilisés, sans sortir de son cadre.

Un exemple de modification conforme à l'invention concerne le panneau de fermeture 13 qui ferme l'enceinte 1 vis-à-vis de l'air ambiant. Il peut avantageusement la faire communiquer avec un poste de chargement et de déchargement des substrats de façon qu'aucune remise à l'air de l'enceinte 1 n'intervienne entre deux traitements.

Dans tous les modes de réalisation précédents, les espèces chargées du plasma sont confinées et ne peuvent arriver en contact avec les parois à température élevée. Par contre, les espèces neutres, atomes, radicaux ou molécules, peuvent réagir à la surface de ces parois à température élevée. Ceci peut, dans certains cas, être un inconvénient non négligeable qui doit être évité.

Il faut alors que le chauffage indépendant soit tel que seuls les substrats soient portés, par exemple par rayonnement, à une température au plus égale à environ 550°C, indépendamment de l'existence du plasma. Les parois du réacteur sont alors froides.

On place alors les gaines contenant les aimants permanents à l'intérieur de l'enceinte étanche 1 et on les refroidit par circulation d'un fluide tel que 25. Entre ces gaines, on dispose un moyen de chauffage par rayonnement, à l'intérieur de l'enceinte 1, le rayonnement étant dirigé vers l'intérieur de celle-ci à l'aide d'un réflecteur approprié pour chaque source de rayonnement. L'enveloppe extérieure transparente des sources de rayonnement, en silice par exemple, les réflecteurs et les gaines contenant les aimants, sont refroidis de façon à constituer une périphérie froide, à l'intérieur de l'enceinte étanche 1, pour le plasma. Seules les pièces à revêtir sont portées à température et aucune interaction ou dépôt ne peut s'effectuer sur le dispositif lui-même que ce soit à partir des espèces chargées ou des neutres.

## Revendications

1. Procédé de traitement chimique, notamment de traitement thermochimique ou de dépôt chimique sous plasma, sur des substrats disposés sur un ou plusieurs porte-substrats, comprenant l'association simultanée d'un plasma à très basse pression, comprise entre 1,33 et 0,00133 Pa et d'un chauffage indépendant, le plasma étant obtenu par l'excitation d'un milieu gazeux réactif à l'aide d'un filament thermoémissif ou d'ondes hyperfréquences, et maintenu à l'intérieur d'une enceinte par un confinement magnétique, caractérisé en ce que le chauffage indépendant comprend une résistance répartie le long des parois de l'enceinte à l'intérieur ou à l'extérieur telle qu'elle permette de porter une partie du contenu de l'enceinte à une température au plus égale à environ 550°C, la proportion des calories apportées par le seul plasma au chauffage des substrats étant négligeable.

2. Procédé selon la revendication 1 caractérisé en ce qu'on effectue le traitement dans un réacteur à parois chaudes, le chauffage indépendant étant disposé à l'extérieur de l'enceinte.

3. Procédé selon la revendication 2 caractérisé en ce qu'on maintient, en outre, le plasma par un confinement électrostatique.

4. Procédé selon l'une des revendications 2 ou 3, caractérisé en ce que les substrats sont à potentiel flottant.

5. Procédé selon l'une des revendications 2 ou 3, caractérisé en ce que les substrats ou le ou chaque porte-substrats sont reliés à une source de polarisation continue ou radiofréquence.

6. Procédé selon la revendication 2, caractérisé en ce que les ondes hyperfréquences servant à exciter le milieu sont des ondes comprises dans la gamme 1 à 10 gigahertz.

7. Procédé selon la revendication 6 caractérisé en ce que les ondes hyperfréquences sont voisines de 2,45 gigahertz.

8. Procédé selon la revendication 1, caractérisé en ce qu'on effectue le traitement dans un réacteur à parois froides, seuls les substrats étant portés par rayonnement à une température au plus égale à environ 550°C.

9. Dispositif pour la mise en oeuvre du procédé tel que défini dans les revendications précédentes, comprenant une enceinte (1) étanche et raccordée à un circuit d'apport (4, 6) d'un ou de plusieurs gaz et à un système de pompage (8) éventuellement régulé par l'intermédiaire d'une jauge (10) et d'une vanne (9), l'ensemble permettant de maintenir dans l'enceinte un débit gazeux sous une pression déterminée, comprise entre 1,33 et 0,00133 Pa, des moyens de génération de plasma constitués soit d'un filament thermoémissif disposé à l'intérieur de l'enceinte, soit d'un générateur d'onde d'hyperfréquences (21) connecté à un dispositif d'excitation (22) du milieu gazeux, une enveloppe de confinement magnétique (18) interne à l'enceinte étanche, caractérisé en ce que les propriétés de ladite enveloppe sont maintenues jusqu'à une température au plus égale à 550°C, et en ce que des moyens de chauffage (3) comprenant une résistance répartie le long des parois de l'enceinte, permettant de porter une partie du contenu de l'enceinte, à une température au plus égale à environ 550°C, en présence du plasma, la température de la paroi de l'enceinte pouvant être très supérieure à cette température.

10. Dispositif selon la revendication 9 caractérisé en ce que la résistance (3) est répartie le long des parois à l'extérieur de cette enceinte.

11. Dispositif selon la revendication 10, caractérisé en ce que l'enceinte comporte une ouverture fermée par un panneau (13) et située hors de la zone chaude du dispositif, ce panneau (13) pouvant fermer l'enceinte (1) vis-à-vis de l'air ambiant ou la faire communiquer avec un poste de chargement et de déchargement des substrats de façon qu'aucune remise à l'air de l'enceinte (1) n'intervienne entre deux traitements.

12. Dispositif selon l'une des revendications 10 ou 11, caractérisé en ce qu'il comporte, en outre, une source de polarisation continue ou radiofréquence (17) connectée aux substrats ou à un ou plusieurs porte-substrats.

13. Dispositif selon la revendication 10 caractérisé en ce que l'enveloppe de confinement magnétique (18) est constituée par une cage multipolaire formée par des aimants permanents (23) dont la structure ne change pas jusqu'à environ 550°C, eux-mêmes entourés par des gaines étanches en matériau amagnétique (24) disposées parallèlement, les aimants présentant d'une gaine à l'autre, en face du volume interne (16) de l'enceinte, une face de polarité successivement différente.

14. Dispositif selon la revendication 13, caractérisé en ce que les aimants (23) sont disposés dans des tubes amovibles placés dans les gaines (24) étanches qui peuvent être sortis de l'enceinte (1) sans établir de communication avec l'air ambiant.

15. Dispositif selon l'une des revendications 13 ou 14, caractérisé en ce que l'enveloppe de confinement magnétique comporte des moyens de confinement électrostatique constitués par des couches de matières isolantes supportant la température régnant dans cette partie de l'enceinte.

16. Dispositif selon l'une quelconque des revendications 13 à 15, caractérisé en ce que les gaines (24) comportent une tubulure étanche permettant le passage d'un fluide thermique (25).

17. Dispositif selon la revendication 16, caractérisé en ce que le fluide thermique s'écoule en circuit fermé à l'aide d'une pompe (26), entre la partie chaude des gaines (24) et une source froide (27).

18. Dispositif selon la revendication 10 caractérisé en ce que l'enceinte étanche (1) et le système de chauffage extérieur à cette enceinte sont entourés par une enceinte extérieure (2) refroidie, étanche et raccordée à un circuit de pompage (28) permettant de faire le vide entre l'enceinte (1) et l'enceinte extérieure refroidie (2).

11

19. Dispositif selon la revendication 9 caractérisé en ce que les moyens de chauffage sont constitués par plusieurs sources de rayonnement disposées à l'intérieur de l'enceinte (1), le rayonnement étant dirigé vers l'intérieur de celle-ci à l'aide d'un réflecteur prévu pour chaque source, l'enveloppe extérieure transparente des sources et les réflecteurs étant refroidis.

20. Dispositif selon la revendication 19, caractérisé en ce que l'enveloppe extérieure des sources est en silice.

## Patentansprüche

1. Verfahren zur chemischen Behandlung, insbesondere zur thermochemischen Behandlung oder zur chemischen Abscheidung, unter Plasma an auf einem oder mehreren Substratträgern angeordneten Substraten, das die gleichzeitige Einwirkung eines Plasmas bei sehr niedrigem Druck im Bereich von 1,33 bis 0,00133 Pa und einer unabhängigen Erhitzung vorsieht, wobei das Plasma durch die Anregung eines reaktiven Gasmediums mit Hilfe eines thermoemissiven Drahtes oder von Ultrahochfrequenzwellen erhalten und im Inneren eines Gehäuses durch einen magnetischen Einschluß gehalten wird, *dadurch gekennzeichnet,* daß die unabhängige Erhitzung einen längs der Wände des Gehäuses im Inneren oder im Außenbereich derart verteilten Widerstand aufweist, daß er ermöglicht, einen Teil des Inhalts des Gehäuses auf eine Temperatur, von höchstens etwa 550 °C zu bringen, wobei der Anteil der zur Erhitzung der Substrate durch das Plasma allein zugeführten Wärme vernachlässigbar ist.

2. Verfahren nach dem Anspruch 1, *dadurch gekennzeichnet,* daß man die Behandlung in einem Reaktionsgefäß mit heißen Wänden durchführt, wobei die unabhängige Erhitzung außerhalb des Gehäuses angeordnet ist.

3. Verfahren nach Anspruch 2, *dadurch gekennzeichnet,* daß man das Plasma außerdem durch einen elektrostatischen Einschluß beibehält.

4. Verfahren nach einem der Ansprüche 2 oder 3, *dadurch gekennzeichnet,* daß die Substrate auf ungeerdetem Potential sind.

5. Verfahren nach einem der Ansprüche 2 oder 3, *dadurch gekennzeichnet,* daß die Substrate oder der oder jeder Substratträger mit einer Dauerpolarisations- oder Hochfrequenzquelle verbunden sind.

6. Verfahren nach dem Anspruch 2, *dadurch gekennzeichnet,* daß die zum Anregen des Mediums dienenden Ultrahochfrequenzwellen Wellen im Bereich von 1 bis 10 Gigahertz sind.

12

7. Verfahren nach dem Anspruch 6, *dadurch gekennzeichnet,* daß die Ultrahochfrequenzwellen nahe von 2,45 Gigahertz sind.

8. Verfahren nach dem Anspruch 1, *dadurch gekennzeichnet,* daß man die Behandlung in einem Reaktionsgefäß mit kalten Wänden durchführt, wobei nur die Substrate durch Strahlung auf eine Temperatur von höchstens etwa 550°C gebracht werden.

9. Vorrichtung zur Durchführung des Verfahrens, wie es in den vorstehenden Ansprüchen definiert ist, die ein dichtes Gehäuse (1), das mit einem Zuführungskreis (4, 6) eines oder mehrerer Gase und mit einem Pumpsystem (8) verbunden ist, das eventuell mittels eines Eichorgans (10) und eines Ventils (9) reguliert wird, welche Gruppe die Aufrechterhaltung eines Gasdurchsatzes bei einem bestimmten Druck im Bereich von 1,33 bis 0,00133 Pa im Gehäuse ermöglicht, Mittel zur Plasmaerzeugung, die entweder aus einem thermoemissiven, im Inneren des Gehäuses angeordneten Draht oder aus einem Ultrahochfrequenzwellengenerator (21) bestehen, der mit einer Einrichtung (22) zum Anregen des Gasmediums verbunden ist, und eine Hülle zum magnetischen Einschluß (18) im Inneren des dichten Gehäuses aufweist, *dadurch gekennzeichnet,* daß die Eigenschaften dieser Hülle bis zu einer Temperatur von höchstens 550°C beibehalten werden und Erhitzungsmittel (3), die einen längs der Wände des Gehäuses verteilten Widerstand aufweisen, es ermöglichen, einen Teil des Inhalts des Gehäuses in Gegenwart des Plasmas auf eine Temperatur von höchstens etwa 550 °C zu bringen, wobei die Temperatur der Wand des Gehäuses viel höher als diese Temperatur sein kann.

10. Vorrichtung nach dem Anspruch 9, *dadurch gekennzeichnet,* daß der Widerstand (3) längs der Wände außerhalb dieses Gehäuses verteilt ist.

11. Vorrichtung nach dem Anspruch 10, *dadurch gekennzeichnet,* daß das Gehäuse eine Öffnung aufweist, die durch eine Platte (13) geschlossen wird und außerhalb der heißen Zone der Vorrichtung liegt, welche Platte (13) das Gehäuse (1) gegenüber der Umgebungsluft abschließen oder es in Verbindung mit einer Station zum Laden und Entladen der Substrate derart bringen kann, daß keine Belüftung des Gehäuses zwischen zwei Behandlungen auftritt.

12. Vorrichtung nach einem der Ansprüche 10 oder 11, *dadurch gekennzeichnet,* daß sie außerdem eine Dauerpolarisations- oder Hochfrequenzquelle (17) aufweist, die mit den Substraten oder einem oder mehreren Substratträgern verbunden ist.

13. Vorrichtung nach dem Anspruch 10, *dadurch gekennzeichnet,* daß die Hülle zum magnetischen Einschluß (18) aus einem vielpoligen Käfig besteht, der aus Dauermagneten (23) gebildet ist, deren Gefüge sich bis etwa 550°C nicht ändert und die von parallel angeordneten dichten Mänteln aus unmagnetischem Material (24) umhüllt sind, wobei die Magnete von einem Mantel zum anderen, dem inneren Volumen (16) des Gehäuses zugewandt, eine Fläche aufeinanderfolgend unterschiedlicher Polarität aufweisen.

14. Vorrichtung nach dem Anspruch 13, *dadurch gekennzeichnet*, daß die Magnete (23) in in den dichten Mänteln (24) angebrachten, auswechselbaren Rohren angeordnet sind, die aus dem Gehäuse (1) entnommen werden können, ohne eine Verbindung mit der Umgebungsluft zu schaffen.

15. Vorrichtung nach einem der Ansprüche 13 oder 14, *dadurch gekennzeichnet*, daß die Hülle zum magnetischen Einschluß Mittel zum elektrostatischen Einschluß aufweist, die aus Schichten von Isolierstoffen gebildet sind, die die in diesem Teil des Gehäuses herrschende Temperatur halten.

16. Vorrichtung nach irgendeinem der Ansprüche 13 bis 15, *dadurch gekennzeichnet*, daß die Mäntel (24) ein dichtes Rohr aufweisen, das den Durchfluß eines Wärmefluids ermöglicht.

17. Vorrichtung nach dem Anspruch 16, *dadurch gekennzeichnet*, daß das Wärmefluid im geschlossenen Kreis mit Hilfe einer Pumpe (26) zwischen dem heißen Teil der Mäntel (24) und einer kalten Quelle (27) umläuft.

18. Vorrichtung nach dem Anspruch 10, *dadurch gekennzeichnet*, daß das dichte Gehäuse (1) und das Erhitzungssystem außerhalb dieses Gehäuses von einem gekühlten, dichten äußeren Behälter (2) umgeben sind, der an einen Pumpkreis (28) angeschlossen ist, der die Schaffung des Vakuums zwischen dem Gehäuse (1) und dem gekühlten äußeren Behälter (2) ermöglicht.

19. Vorrichtung nach dem Anspruch 9, *dadurch gekennzeichnet*, daß die Erhitzungsmittel aus mehreren Strahlungsquellen bestehen, die im Inneren des Gehäuses (1) angeordnet sind, wobei die Strahlung mit Hilfe eines für jede Quelle vorgesehenen Reflektors zum Inneren desselben gerichtet wird und die äußere transparente Hülle der Quellen und die Reflektoren gekühlt werden.

20. Vorrichtung nach dem Anspruch 19, *dadurch gekennzeichnet*, daß die äußere Hülle der Quellen aus Siliziumdioxid ist.

## Claims

1. A process for the chemical treatment, particularly the thermochemical or chemical deposition treatment under a plasma, of substrates disposed on one or more substrate carriers, the said process comprising the simultaneous association of a plasma at very low pressure, of between 1.33 and 0.00133 Pa, and independent heating, the plasma being obtained by the excitation of a reactive gaseous medium by means of a thermoemissive filament or hyperfrequency waves and maintained within an enclosure by a magnetic confinement, characterised in that the independent heating comprises a resistor distributed along the walls of the enclosure, on the inside or on the outside, in such a way that it makes it possible to raise a part of the contents of the enclosure to a temperature at most equal to approx. 550°C, the proportion of heat provided by the plasma alone to the heating of the substrates being negligible.

2. A process according to Claim 1, characterised in that the treatment is carried out in a reactor with heated walls, the independent heating being disposed outside the enclosure.

3. A process according to Claim 2, characterised in that the plasma is also maintained by an electrostatic confinement.

4. A process according to one of Claims 2 or 3, characterised in that the substrates have a floating potential.

5. A process according to one of Claims 2 or 3, characterised in that the substrates or the substrate carrier or carriers is/are linked to a direct or radio frequency polarisation source.

6. A process according to Claim 2, characterised in that the hyperfrequency waves used for energising the medium are waves within the range from 1 to 10 gigahertz.

7. A process according to Claim 6, characterised in that the hyperfrequency waves are around 2.45 gigahertz.

8. A process according to Claim 1, characterised in that treatment is carried out in a cold wall reactor, only the substrates being raised by radiation to a temperature which is at most equal to approx. 550°C.

9. An apparatus for carrying out the process as defined in the preceding Claims, comprising a sealed enclosure (1) connected to a circuit (4, 6) supplying one or more gases and to a pumping system (8) possible controlled by means of a gauge (10) and a valve (9), the assembly making it possible to maintain in the enclosure a flow of gas at a specific pressure of between 1.33 and 0.00133 Pa, plasma generating means consisting either of a thermo-emissive filament disposed inside the enclosure or a hyperfrequency wave generator (21) connected to means (22) for energising the gaseous medium, a magnetic confinement casing (18) inside the sealed enclosure, characterised in that the properties of the said casing are maintained up to a temperature which is at the most equal to approx. 550°C in the presence of the plasma, the temperature of the enclosure wall possibly being very much higher than this temperature.

10. An apparatus according to Claim 9, characterised in that the resistor (3) is distributed along the walls on the outside of the enclosure.

11. An apparatus according to Claim 10, characterised in that the enclosure comprises an opening which is closed by a panel (13) and is situated outside the heated zone of the apparatus, the said panel (13) being capable of closing the enclosure (1) off from the ambient air or of allowing it to communicate with a substrate loading and unloading station so that between any two treatments there is no communication between the air and the enclosure (1).

12. An apparatus according to one of Claims 10 or 11, characterised in that it further comprises a direct or radio frequency polarisation source (17) connected to the substrates or to one or more substrate carriers.

13. An apparatus according to Claim 10, characterised in that the magnetic confinement casing (18) consists of a multi-pole cage formed by permanent magnets (23), the structure of which does not change up to about 550°C, and which are themselves enclosed in sealed sheaths of a nonmagnetic material (24) disposed in a parallel manner, the magnets having from one sheath to the other and facing the space (16) inside the enclosure a side of successively different polarity.

14. An apparatus according to Claim 13, characterised in that the the magnets (23) are disposed in removable tubes placed in the tightly sealed sheaths (24) which may be removed from the enclosure (1) without any communication being established with the ambient air.

15. An apparatus according to one of Claims 13 or 14, characterised in that the magnetic confinement casing comprises electrostatic confinement means consisting of layers of insulating materials which can withstand the temperature obtaining in this part of the enclosure.

16. An apparatus according to any one of Claims 13 to 15, characterised in that the sheaths (24) comprise a sealed pipe through which a thermal fluid (25) can pass.

17. An apparatus according to Claim 16, characterised in that the thermal fluid flows in a closed circuit, by means of a pump (26), within the hot part of the sheaths (24) and a cold source (27).

18. An apparatus according to Claim 10, characterised in that the sealed enclosure (1) and the heating system outside this enclosure are surrounded by a cooled sealed outer enclosure (2) connected to a pumping circuit (28) which makes it possible to establish a vacuum between the enclosure (1) and the cooled outer enclosure (2).

19. An apparatus according to Claim 9, characterised in that the heating means consist of a plurality of radiation sources disposed inside the enclosure (1), the radiation being directed towards the interior of this latter by a reflector provided for each source, the transparent outer casing over the sources and the reflectors being cooled.

20. An apparatus according to Claim 19, characterised in that the outer casing enclosing the sources consists of silica.

FIG.1

FIG.2